# EUROPEAN PATENT APPLICATION

(11) **EP 3 657 410 A1**
(43) Date of publication of application: **27.05.2020**
(21) Application number: 18907411.5
(22) Date of filing: 10.10.2018
(51) Int. Cl.: G06Q 10/06, G06Q 50/26, G06F 17/50

(54) **ENERGY TRANSITION DECISION SUPPORT METHOD BASED ON TECHNOLOGY-ECONOMY-REAL PARTICIPANT-COMPUTER AGENT INTERACTIVE SIMULATION**

(30) Priority: 22.02.2018 CN 201810153759
(71) Applicant: Nari Technology Co., Ltd., Jiangsu 211106 (CN); State Grid Electric Power Research Institute, Nanjing, Jiangsu 211106 (CN); NARI Group Corporation, Nanjing, Jiangsu 211106 (CN)
(72) Inventor: XUE, Yusheng, Nanjing, Jiangsu 211106 (CN); CAI, Bin, Nanjing, Jiangsu 211106 (CN); WEN, Yan, Nanjing, Jiangsu 211106 (CN); YANG, Xinxin, Nanjing, Jiangsu 211106 (CN)
(74) Representative: Grünecker Patent- und Rechtsanwälte PartG mbB
(86) International application number: PCT/CN2018/109566
(87) International publication number: WO 2019/161666

(57) **Abstract**

The present invention discloses an energy transition decision support method based on technical-economic-real participant-computer agent interactive simulation, relating to the technical field of energy planning. According to the present invention, transition decisions of participants are added to an objective technical-economic model of energy system, and decision-making behaviors of real participants and computer agents are taken as input of the objective technical-economic model at each simulation step. The simulation results under the driving of behavior decisions at the previous stage are taken as a basis to adjust decisions of the participants at the next stage, so that interaction influence of technical-economic-multiplayer game behaviors is reflected in the time track of the simulation results. According to the present invention, the negative influence caused by a deviation of computer agents in simulating behaviors of important roles is reduced, and the advantages of real participants and computer agents in simulating human behaviors are taken into account.

## Description

### Technical Field

The present invention relates to the technical field of energy planning, and particularly relates to an energy transition decision support method based on technical-economic-real participant-computer agent interactive simulation.

### Background

Facing resource depletion, environmental pollution, climate change and other pressures, clean transition of energy has become an irreversible trend in China or even around the world.

Energy transition is not only a technical-economic issue, but also affected by behaviors of individual participants and factors such as policies and supervisions. Therefore, in addition to physical and economic laws such as running and market mechanisms of an accrued and objective energy system, corresponding research methods should also include subjective decision-making behaviors of related personnel of the energy system.

At present, multiple methods for supporting energy transition decision-making are proposed, and advantages and disadvantages of each method are shown in table 1.

**Table 1 Classification of Methods for Supporting Energy Transition Decision-making**

| **Name** | **Research contents** | **Advantages** | **Disadvantages** |
|---|---|---|---|
| Qualitative socio-technical transition framework | Analyze various subjective and objective influence factors causing energy transition | The factors considered are comprehensive, and the influences of subjective behaviors of human beings are emphasized | Technical-economic details such as balance between supply and demand, resource constraints, and transition costs are ignored, and it lacks quantitative and deductive capabilities |
| Technical-economic simulation | This includes the most mainstream energy transition research methods at present, with representative models such as MESSAGE and TIMES. Energy transition targets and pathways in certain countries/regions are simulated, evaluated and optimized using a simulation model | Based on a mathematical model, objective technical-economic characteristics of an energy system/market are simulated in details | Assumptions such as rational choices, utility, benefit maximization and perfect information on which the research is based do not comply with actual situations; will and behaviors of participants are not taken into consideration |
| Technical-economic simulation in given decision-making behavior scenarios | A "story line" of energy transition (qualitative description scenario) is formed through discussions between interested parties, and verified through quantitative technical-economic simulation | A "story line" is formed in a form of a multi-party seminar, where not only influence of human subjective decision-making behaviors on energy transition is taken into account, but also economic-technical simulation is combined | In a simulation process, human subjective decision-making behaviors may not interact and play a game with mathematical models, such that actual situations of energy transition problems cannot be described accurately |
| Economic-technical-computer agent joint simulation | Based on technical-economic simulation, computer agents playing different roles (such as generation companies and electricity consumers) are established, and behaviors of certain types of decision makers are taken into account in an energy transition process | Human subjective decision-making behaviors may interact and play a game with mathematical models to promote an energy transition simulation process together | Computer agents are unable to accurately simulate behaviors of human beings, and if deviations occur in behavior description of key participants, a great influence may be brought to the accuracy of the simulation result |

In general, current energy transition decision support methods cannot reflect influences of subjective decision-making behaviors well. A predominant quantitative technical-economic model, can merely reflect behavioral preferences of decision makers in a limited fashion by setting scenario parameters before the start of simulation calculation, and cannot dynamically adjust the behavioral preferences according to actual calculation results during a simulation process.

A small number of models may simulate subjective decision-making behaviors of participants by constructing computer agents, and reflect, by means of interaction between the computer agents and objective data models, influences of subjective decision-making behaviors of the participants on energy transition. However, energy transition decision-making is a complex problem that involves factors in various fields, such as technology, economy, politics, society, and values, and the computer agents are unable to accurately simulate such decisions, in particular, non-rational decisions.

In addition, in the context of clean energy transition, energy enterprises are required to play market games in multiple energy markets which have complex interaction relationships, and formulate transition strategies. At present, there are already mature quantitative analysis tools for evaluating a specific energy engineering investment. However, the evaluation on costs/benefits of an energy engineering project alone without taking energy environments of the entire country/region and decisions of participants into consideration is generally biased. In current energy transition research, evaluations on benefits, investment appeal and other aspects of energy enterprises, as well as tools for supporting decision-making of people who formulate enterprise transition strategies are almost blank.

### Summary

The purpose of the present invention is to: providing a decision support method based on technical-economic-real participant-computer agent interactive simulation, regarding the limitations of existing energy transition decision support methods in the aspect of decision-making behaviors of participants. The present method is applicable to long-term transition strategy planning of energy systems or energy enterprises, and can be applied in national/regional energy transition or energy enterprise transition research.

Specifically, the present invention is implemented by using the following technical solution, which includes the following steps:
step 1: designing a set of simulation experiments to support energy transition decision-makings of an actual object system (wherein the actual object system comprises energy systems and energy enterprises), the set of simulation experiments comprising at least one simulation experiment, selecting one simulation experiment as a current simulation experiment, and proceeding to step 2;
step 2: for the current simulation experiment, setting parameters of the objective mathematical model and behavior models of computer agents according to the status and predictive information of the actual object system, wherein the objective mathematical model describes technical and economic characteristics of the actual object system and is able to calculate various technical-economic indicators of the actual object system according to input decision-making behaviors, the computer agents are configured to simulate the decision-making behaviors of participants in the energy transition decision, and the behavior models parameters of the computer agents are determined according to behavior models of participants represented by computer agents;
step 3: setting a human-computer interaction interface, configured to obtain subjective decision-making behaviors input by real participants, and distributing roles played by the real participants in the current simulation experiment;
step 4: before a current simulation step of the current simulation experiment starts, obtaining the subjective decision-making behaviors input by the real participants based on determination on current information through the human-computer interaction interface, wherein the subjective decision-making behaviors comprise a behavior of a government agency of adjusting a renewable energy subsidy decision according to an actual development status of renewable energy and competitive bidding/investment/transformation/decommission decision-making behaviors of energy providers;
step 5: simulating the decision-making behaviors of participants represented by computer agents according to behavior models parameters;
step 6: inputting the obtained subjective decision-making behaviors of the real participants and the decision-making behaviors simulated by computer agents into the objective mathematical model as input, so that the objective mathematical model calculates the technical-economic indicators of the actual object system in the current simulation step;
step 7: if the current simulation step does not reach a total number of simulation steps of the current simulation experiment, feeding the calculation results of the objective mathematical model in step 6 back to the real participants and computer agents as a basis for subsequent decision adjustment, proceeding to the next simulation step, and returning to step 4; otherwise, recording the simulation results, finishing the current simulation experiment, and proceeding to step 8;
step 8: if the set of simulation experiments is not finished yet, selecting another simulation experiment as the current simulation experiment, and returning to step 2, otherwise, proceeding to step 9;
step 9: determining whether more simulation results are required to support the energy transition decision-makings of the actual object system, if yes, proceeding to step 1, and designing a new set of simulation experiments, otherwise, ending the experiment.

Furthermore, the real participants include the government agency, energy providers, and/or energy consumers.

Furthermore, the real participants play important roles in the simulation experiments, and participants represented by computer agents play secondary roles.

Furthermore, the subjective decision-making behaviors of the real participants include rational and non-rational decision-making behaviors, while the decision-making behaviors simulated by computer agents are rational decision-making behaviors.

Furthermore, the real participants and computer agents adjust decisions in the next simulation step according to the technical-economic indicators of the actual object system calculated by the objective mathematical model in the current simulation step, so as to implement interaction between subjective energy transition decision-making behaviors and the objective energy system mathematical model in each simulation step, thereby achieving interaction between decision-making behaviors of different participants among each simulation step.

Furthermore, in step 9, whether more simulation experiments need to be organized is determined according to whether the obtained simulation results are sufficient to support an actual decision making and in consideration of required manpower, time costs and potential benefits of organizing more simulation experiments.

Compared with the prior art, the beneficial effects of the present invention are reflected below: in the present invention, subjective decision-making behaviors of stakeholders in an energy transition process are added to a quantitative technical-economic model of the energy system, and taken as input parameters at each simulation step. Adjustments of decisions of the participants at the next simulation step are made by taking the simulation results under the diving of behavior decisions at the previous simulation step as a basis, so that interaction influence of technical-economic-multiplayer game behaviors is reflected in the time track of the simulation result. In the process where subjective decision-making behaviors are taken into account, the computer agents simulate a large amount of secondary roles involved in the energy transition process, which reduces the requirement on the number of real participants, and a small number of real participants play important roles and simulate rational and non-rational decision-making behaviors concerning energy transition, in particular, non-rational decision-making behaviors, which reduces negative influence caused by deviations of computer agents in simulating behaviors of important roles, combining the advantages of real participants and computer agents in simulating human behaviors together.

### Brief Description of the Drawings

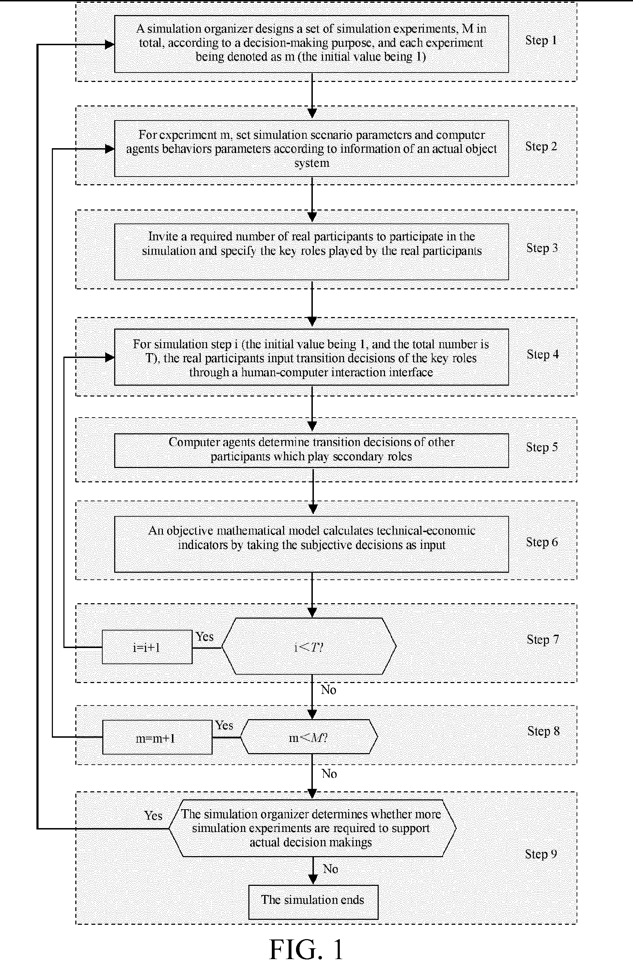

FIG. 1 is a flow chart of the method of the present invention.

### Detailed Description

The present invention is described in detail below with reference to the attached drawing and the specific embodiments.

### Embodiment 1:

The present invention discloses an energy transition decision support method based on technical-economic-real participant-computer agent interactive simulation, which can be applied in planning decision-makings of national/regional energy transition optimization or transition strategies of conventional energy enterprises. The present embodiment takes a case that the government agency adjusts renewable energy subsidies in the context of different rates of technological advance in renewable energy technology to guide national energy transition as an example, the specific steps are provided as follows:
step 1: an simulation organizer designs a set of simulation experiments to support energy transition decision-making (including analysis or optimization on national energy planning by a government agency, analysis or optimization on transition strategy planning by a certain energy enterprise, and the like) of an actual object system (energy systems, energy enterprises, and the like), wherein each experiment is denoted by m, m = 1, 2, 3, ..., M, and M represents the total number of experiments. In view of the present embodiment, the simulation organizer is a policy formulator, who organizes three simulation experiments to respectively represent three scenarios in which the rates of technological advance in renewable energy technology are high, medium, and low.
Step 2: for the simulation experiment m, parameters of the objective mathematical model and behavior models of computer agents used in the current simulation experiment are set according to the status and predictive information of the actual object system, wherein the objective mathematical model describes technical and economic characteristics of the actual object system and is able to calculate various technical-economic indicators of the actual object system according to input of decision-making behaviors. The computer agents are configured to simulate the rational decision-making behaviors of a large number of secondary participants in the energy transition, which reduces the requirement on the number of real participants, and the computer agents may represent participants under different behavioral patterns by setting different parameter values. In specific implementation of the present embodiment, the computer agents play the role of small energy providers. Different decisions may be made according to different rates of return on investment (taking renewable energy subsidies into account) in various energy technologies based on behavioral models of small energy providers. Energy technologies with rate of return on investment exceeding a certain percentage are chosen as alternative options, and the technology with the highest rate of return is selected. The upper limit of investment is a certain percentage of the total net asset.
Step 3: a human-computer interaction interface is set and configured to obtain subjective decision-making behaviors input by real participants (e.g. government agencies, energy providers, and energy consumers), and roles played by real participants in the current simulation experiment are distributed. Correspondingly, a required number of real participants in the simulation scenario are invited to input subjective decisions by means of the human-computer interaction interface during the simulation process, and the real participants are notified of roles to be played during the simulation. Both experts with abundant professional knowledge and ordinary decision makers not enriched with the professional knowledge can act as the real participants, so that the influence on energy transition caused by decision-making behaviors of different levels is simulated. There should only be a small number of real participants, who may play important roles to simulate rational and non-rational subjective decision-making behaviors, particularly the non-rational decision-making behaviors. In view of the present embodiment, a policy formulator and some energy enterprises decision makers may act as real participants to simulate policy formulation and transition strategies decision-makings respectively in the simulation experiment.

As can be known from the above, since the simulation experiments not only adopt the objective mathematical model describing energy system technologies and economic characteristics, but also use the human-computer interaction interface through which the real participants such as government agencies, energy providers, and energy consumers can input transition decisions, and the computer agents can simulate the rational decision-making behaviors, the simulation is able to combine advantages of experimental economics and computational economics together, and achieves the effect of interactive simulation between subjective decision-making behaviors of a large number of computer agents and a small number of actual real participants and an objective mathematical model.

Step 4: before each simulation step i of the present simulation experiment starts (i = 1, 2, 3, ..., T, and T represents the total number of simulation time steps), each real participant conducts a decision-making behavior based on determination on current information, and inputs the subjective decision-making behaviors through the human-computer interaction interface, wherein the subjective decision-making behaviors include a behavior of a government agency of adjusting the renewable energy subsidy according to the actual development status of renewable energy and competitive bidding/investment/transformation/decommission decision-making behaviors of energy providers. In view of the present embodiment, energy transition planning is conducted from 2015 to 2030 by taking a year as one simulation step. In any simulation year during the planning period, the policy formulator simulates publishing subsidies of multiple types of renewable energy such as wind power, photovoltaic power, and solar thermal power on that year, and on this basis, role-players of energy enterprises may make investment decisions on the multiple types of energy according to their respective strategic directions.

Step 5: computer agents simulate the decision-making behaviors of the participants according to behavior models parameters. In view of the present embodiment, the behavior models of the computer agents determine the investment decisions according to the subsidies of multiple types of renewable energy published by the policy formulator and other scenario parameters.

Step 6: the objective mathematical model calculates the technical-economic indicators of the actual object system in the simulation step i by taking the decision-making behaviors of real participants and computer agents as input. In view of this embodiment, status information such as the development scales of energy technologies in the energy system after the simulation step i are calculated, and the participants may adjust the investment decisions according to the calculation results before the simulation step i+1 starts, so that interaction between the subjective energy transition decision-making behaviors and objective energy system mathematical model is implemented in each simulation step, and interaction between decision-making behaviors of different participants is implemented among each simulation step.

Step 7: if i < T, then i = i + 1, and the calculation results of the objective mathematical model in step 6 is fed back to the real participants and the computer agents as a basis for subsequent decision adjustment, and the process returns to step 4; otherwise, simulation results are recorded, the simulation experiment with the serial number being m is ended, and the process proceeds to step 8. In view of the present embodiment, the simulation may continue until 2030.

Step 8: if m < M, then m = m + 1, and the process returns to step 2, otherwise, the set of experiments is ended. In view of the present embodiment, the simulation is conducted in three scenarios in which the rates of technological advance in renewable energy technology are high, medium, and low, until simulations in all the scenarios are completed.

Step 9: the simulation organizer determines whether more simulation results are required to support the transition decision-making of the actual object system, if yes, the process proceeds to step 1, and new simulation experiments need to be designed, otherwise, the simulation experiments are ended. Specifically, whether more simulation experiments need to be organized is determined according to whether the obtained simulation results are sufficient to support the actual decisions making and in consideration of required manpower and time costs and potential benefits of organizing more simulation experiments. In view of the present embodiment, if parameter settings of the three rates of technological advance scenarios are inappropriate or the number of scenarios is insufficient, the simulation organizer may need to reorganize the simulation experiments, otherwise, the simulation organizer may end the simulation experiments, and make a renewable energy subsidy decision advice for the actual object system by taking the simulation results as reference bases.

Although the present invention is disclosed above as preferred embodiments, the embodiments are not intended to limit the present invention. Any equivalent changes or modifications, without departing from the spirit or scope of the present invention, should also be considered as falling within the scope of protection of the present invention. Therefore, the scope of protection of the present invention should be based on the content defined by the claims of the present application.

## Claims

1. An energy transition decision support method based on technical-economic-real participant-computer agent interactive simulation, comprising the following steps:
step 1: designing a set of simulation experiments to support energy transition decision-makings of an actual object system (wherein the actual object system comprises energy systems and energy enterprises), the set of simulation experiments comprising at least one simulation experiment, selecting one simulation experiment as a current simulation experiment, and proceeding to step 2;
step 2: for the current simulation experiment, setting parameters of the objective mathematical model and behavior models of computer agents according to the status and predictive information of the actual object system, wherein the objective mathematical model describes technical and economic characteristics of the actual object system and is able to calculate various technical-economic indicators of the actual object system according to input decision-making behaviors, the computer agents are configured to simulate the decision-making behaviors of participants in the energy transition decision, and the behavior models parameters of the computer agents are determined according to behavior models of participants represented by computer agents;
step 3: setting a human-computer interaction interface, configured to obtain subjective decision-making behaviors input by real participants, and distributing roles played by the real participants in the current simulation experiment;
step 4: before a current simulation step of the current simulation experiment starts, obtaining the subjective decision-making behaviors input by the real participants based on determination on current information through the human-computer interaction interface, wherein the subjective decision-making behaviors comprise a behavior of a government agency of adjusting a renewable energy subsidy decision according to an actual development status of renewable energy and competitive bidding/investment/transformation/decommission decision-making behaviors of energy providers;
step 5: simulating the decision-making behaviors of participants represented by computer agents according to behavior models parameters;
step 6: inputting the obtained subjective decision-making behaviors of the real participants and the decision-making behaviors simulated by computer agents into the objective mathematical model as input, so that the objective mathematical model calculates the technical-economic indicators of the actual object system in the current simulation step;
step 7: if the current simulation step does not reach a total number of simulation steps of the current simulation experiment, feeding the calculation results of the objective mathematical model in step 6 back to the real participants and computer agents as a basis for subsequent decision adjustment, proceeding to the next simulation step, and returning to step 4; otherwise, recording the simulation results, finishing the current simulation experiment, and proceeding to step 8;
step 8: if the set of simulation experiments is not finished yet, selecting another simulation experiment as the current simulation experiment, and returning to step 2, otherwise, proceeding to step 9;
step 9: determining whether more simulation results are required to support the energy transition decision-makings of the actual object system, if yes, proceeding to step 1, and designing a new set of simulation experiments, otherwise, ending the experiment.

2. The energy transition decision support method based on technical-economic-real participant-computer agent interactive simulation according to claim 1, wherein the real participants comprise the government agency, energy providers, and/or energy consumers.

3. The energy transition decision support method based on technical-economic-real participant-computer agent interactive simulation according to claim 1, wherein the real participants play important roles in the simulation experiments, and participants represented by computer agents play secondary roles.

4. The energy transition decision support method based on technical-economic-real participant-computer agent interactive simulation according to claim 1, wherein the subjective decision-making behaviors of the real participants comprise rational and non-rational decision-making behaviors, and the decision-making behaviors simulated by computer agents are rational decision-making behaviors.

5. The energy transition decision support method based on technical-economic-real participant-computer agent interactive simulation according to claim 1, wherein the real participants and computer agents adjust decisions in the next simulation step according to the technical-economic indicators calculated by the objective mathematical model in the current simulation step, so as to implement interaction between subjective energy transition decision-making behaviors and the objective energy system mathematical model in each simulation step, thereby achieving interaction between decision-making behaviors of different participants among each simulation step.

6. The energy transition decision support method based on technical-economic-real participant-computer agent interactive simulation according to claim 1, wherein: in step 9, whether more simulation experiments need to be organized is determined according to whether the obtained simulation results are sufficient to support an actual decision making and in consideration of required manpower, time costs and potential benefits of organizing more simulation experiments.
